# EUROPEAN PATENT SPECIFICATION

(11) **EP 2 584 646 B1**
(45) Date of publication and mention of the grant of the patent: **23.08.2017**
(21) Application number: 12188522.2
(22) Date of filing: 15.10.2012
(51) Int. Cl.: G02B 6/38, G02B 6/42, H01Q 1/50, H01R 27/02

(54) **All-outdoor microwave enclosure having a built-in memory cardholder**
Komplett-Außenraum-Mikrowellengehäuse mit integriertem Speicherkartenhalter
Enceinte à micro-ondes extérieure ayant un titulaire de carte mémoire intégré

(30) Priority: 20.10.2011 US 201161549668 P
(43) Date of publication of application: 24.04.2013
(73) Proprietor: ZTE (USA), Inc., Richardson, TX 75080 (US)
(72) Inventor: Nealis, Edwin, Cary, NC North Carolina 27513 (US); Kochetov, Andrey, Cary, NC North Carolina 27519 (US)
(74) Representative: Awapatent AB

(56) References cited:
- WO-A1-2011/100633
- AU-A4- 2009 100 048
- US-A1- 2007 019 963
- US-A1- 2011 211 792
- US-B1- 7 043 280

## Description

### TECHNICAL FIELD

The present invention relates to the equipment for microwave radio communication, and in particular, to an all-outdoor microwave enclosure having a built-in memory cardholder.

### BACKGROUND

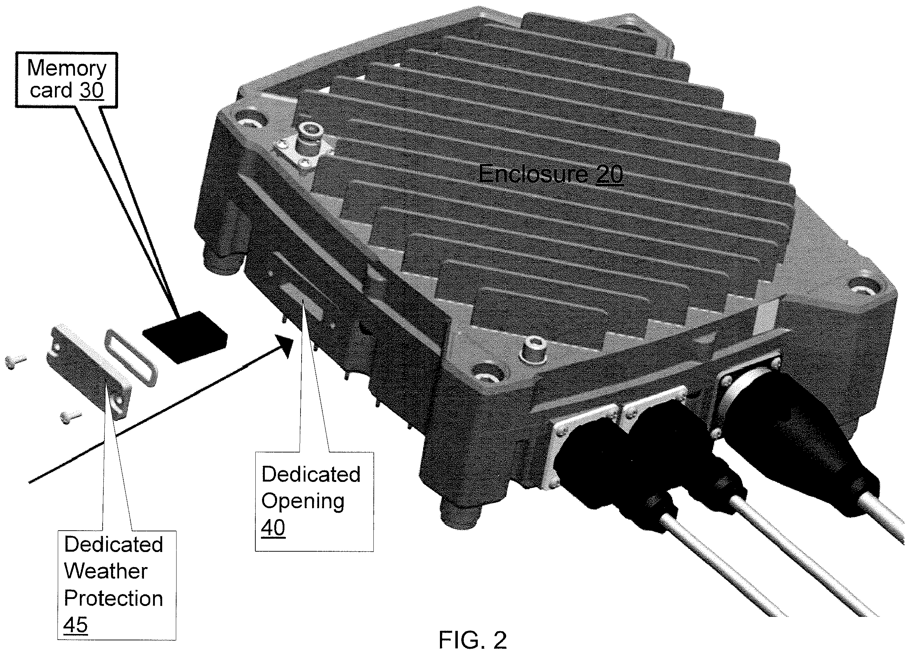

Microwave communication systems commonly consist of many outdoor enclosures for housing microwave transmitter/receiver equipment. Each outdoor microwave enclosure has one or more input/output (I/O) connection ports for tributary connection or connection to support the equipment. These I/O connection ports need to be protected from the external environment, e.g., extreme weather conditions. An outdoor microwave communication enclosure often includes a storage device for storing data including licensing information, configuration parameters, software, etc., which data supports the operation of the electronic hardware in the system. Traditionally, it is difficult to extract the data from the hardware in the event of a hardware failure. As a result, the data would have to be stored outside the enclosure's hardware in order to be loaded into a replacement unit. An alternative approach as described in FIG. 2 below is to create a dedicated opening in the enclosure for the storage device. Nevertheless, this additional opening would impose a challenge to the full weatherproof of the enclosure, which is critical to the normal operation the enclosure.

AU 2009100048 A4 discloses an enclosure having a combined USB connector and memory card socket.

### SUMMARY

One objective of the present invention is to provide an enclosure design that allows a technician to insert/remove a storage device into/from an all-outdoor enclosure without requiring any additional opening on the enclosure. By providing access to a removable storage device, the data can be loaded into the storage device and easily removed and reinstalled in another enclosure in the event of hardware failure replacement or hardware upgrade. This approach is more convenient than storing the data external to the microwave enclosure's hardware and provides greater flexibility in data and licensing management.

According to some aspects of embodiments, an all-outdoor microwave transmit/receive enclosure comprises an enclosure housing and one or more I/O connection ports that are mounted on one side of the enclosure housing. The enclosure housing contains a removable communication connector and a removable memory card. Both the removable communication connector and the removable memory card can be inserted into or removed from the enclosure housing via a particular I/O connection port.

The removable communication connector is an optical transceiver. The optical transceiver may have a standard form-factor selected from the group consisting of CFP, SFF, SFP, SFP+, XFP, and BiDi.

According to some embodiments, the removable memory card is a flash memory card, e.g., a form-factor micro SD card.

According to some embodiments, the removable memory card is configured to store at least one of licensing information, configuration parameters, and software for operating the enclosure.

The enclosure housing further contains a printed circuit board adjacent the particular I/O connection port, and a first side of the printed circuit board is attached to a cage for hosting the removable communication connector and a second side opposite the first side of the printed circuit board is attached to a cardholder for hosting the removable memory card.

Each I/O connection port is configured to be coupled to a respective cable plug-in terminal and the cable plug-in terminal has a weather protection shielding the I/O connection port from the external environment.

According to some aspects of a method of replacing a first memory card inside a microwave transmit/receive enclosure with a second memory card comprises unplugging a cable plug-in terminal from an I/O connection port of the enclosure, wherein there are a first memory card and a communication connector inside the enclosure and both the first memory card and the communication connector are near the I/O connection port; removing the first memory card from the enclosure through the I/O connection port; inserting a second memory card into the enclosure through the I/O connection port to occupy a space inside the enclosure that used to be occupied by the first memory card; and plugging the cable plug-in terminal back into the I/O connection port.

According to some embodiments, the method further comprises:
removing the communication connector from the enclosure through the I/O connection port; and inserting a replacement communication connector into the enclosure through the I/O connection port to occupy a space inside the enclosure that used to be occupied by the removed communication connector.

The enclosure includes a printed circuit board adjacent the I/O connection port, and a first side of the printed circuit board is attached to a cage for housing the communication connector and a second side opposite the first side of the printed circuit board is attached to a cardholder for hosting one of the first memory card and the second memory card.

According to some embodiments, the communication connector is an optical transceiver that has a standard form-factor selected from the group consisting of CFP, SFF, SFP, SFP+, XFP, and BiDi.

According to some embodiments, the removable memory card is a flash memory card, e.g., a form-factor micro SD card.

According to some embodiments, the removable memory card is configured to store at least one of licensing information, configuration parameters, and software for operating the enclosure.

The I/O connection port is configured to be coupled to the cable plug-in terminal and the cable plug-in terminal has a weather protection shielding the I/O connection port from the external environment.

### BRIEF DESCRIPTION OF THE DRAWINGS

Different aspects of the present invention as well as features and advantages thereof will be more clearly understood hereinafter as a result of a detailed description of embodiments of the present invention when taken in conjunction with the accompanying drawings, which are not necessarily drawn to scale. Like reference numerals refer to corresponding parts throughout the several views of the drawings.
FIG. 1 depicts an outdoor microwave enclosure with I/O connectors having weather protection according to some embodiments.
FIG. 2 depicts an outdoor microwave enclosure utilizing a dedicated opening in the enclosure for hosting removable memory card according to some embodiments.
FIG. 3 depicts an outdoor microwave enclosure having an I/O connection port shared by a removable memory card and an optical transceiver according to some embodiments.
FIG. 4 depicts that the memory card is installed in the I/O connection port according to some embodiments.
FIG. 5 depicts that an SFP (Small Form-factor Pluggable) transceiver is being inserted into the I/O connection port according to some embodiments.
FIG. 6 depicts that the SFP transceiver is installed in the I/O connection port according to some embodiments.
FIG. 7 depicts that the I/O connector with weather protection is installed back on the enclosure according to some embodiments.
FIG. 8 depicts a printed circuit card inside the enclosure with an SFP cage and a memory cardholder attached to two opposite sides of the board according to some embodiments.
FIG. 9 depicts that the memory card is inserted into the memory cardholder according to some embodiments.
FIG. 10 depicts a cross-sectional view of the enclosure with the connector's weather protection removed and the SFP transceiver removed but the memory card installed according to some embodiments.
FIG. 11 depicts a cross-sectional view of the enclosure with the connector protection removed but both the SFP transceiver and the memory card install according to some embodiments.

### DESCRIPTION OF EMBODIMENTS

Reference will now be made in detail to embodiments, examples of which are illustrated in the accompanying drawings. In the following detailed description, numerous non-limiting specific details are set forth in order to assist in understanding the subject matter presented herein. It will be apparent, however, to one of ordinary skill in the art that various alternatives may be used without departing from the scope of the present invention and the subject matter may be practiced without these specific details. For example, it will be apparent to one of ordinary skill in the art that the subject matter presented herein can be implemented on many types of outdoor radios systems.

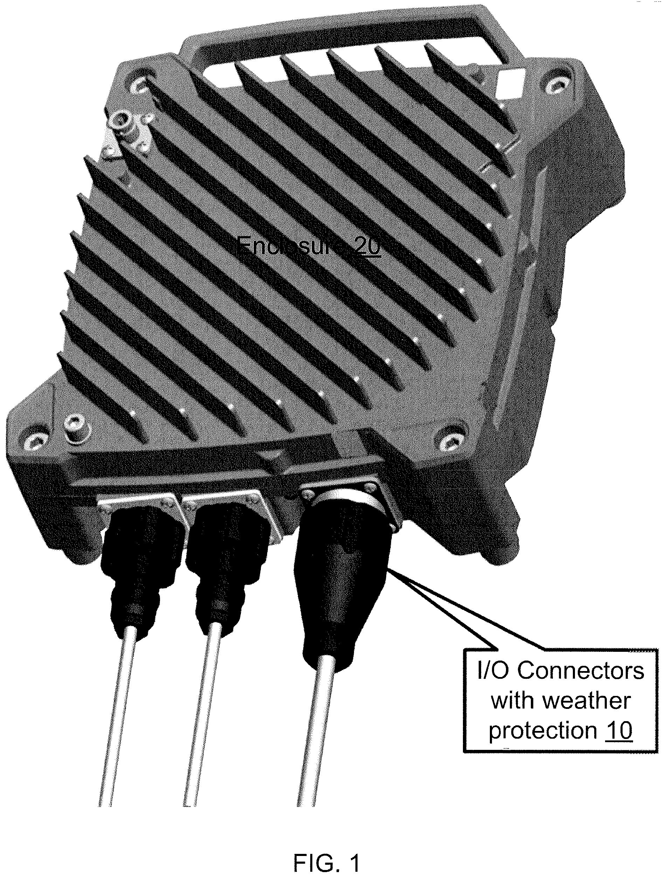

FIG. 1 depicts an outdoor microwave enclosure 20 with multiple I/O connectors 10, each connector having weather protection according to some embodiments. As described above, the enclosure 20 houses a storage device (e.g., a flash memory card) for storing data such as licensing information, configuration parameters, and software for operating the enclosure 20. The connector types may include Ethernet and fiber optic connections, etc.

In order to make it easier to replace the memory card, FIG. 2 depicts that there is a dedicated opening 40 in the enclosure 20 for hosting the removable memory card 30 according to some embodiments. But as noted above, this approach would require a dedicated set of weather protection 45 to protect the memory card 30 from extreme weather conditions. For example, beside the memory card 30 and a corresponding memory cardholder inside the enclosure 20 (not shown in the figure) a cover, gasket, and screws are required for this approach.

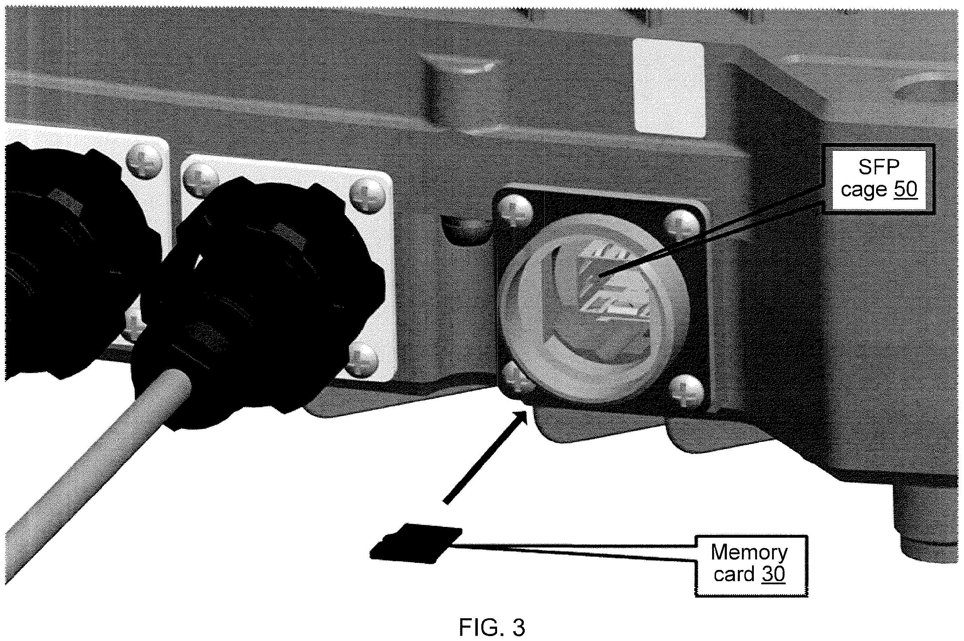

FIG. 3 depicts that the outdoor microwave enclosure 20 includes an I/O connection port shared by the removable memory card 30 and an optical transceiver according to some embodiments. In this example, the memory card 30 shares the I/O connection port hosting an optical transceiver (e.g., an SFP transceiver). As shown in the figure, there is an SFP cage 50 inside the I/O connection port. The memory card 30 can be inserted into the enclosure 20 through the I/O connection port after the I/O connector is removed. It should be noted that the I/O connection port may be used for hosting other types of optical transceivers having a different form-factor standard, e.g., CFP, SFF, SFP, SFP+, XFP, and BiDi. The flash memory card may have a standard form-factor, e.g., a micro SD card. One requirement for the I/O connection port is that it is large enough to have additional space for allowing the memory card to be plugged into a corresponding memory cardholder inside the enclosure 20 without causing substantial interference to the other existing I/O connectors. This approach does not require any change to the geometrical dimensions of the current design of an enclosure housing.

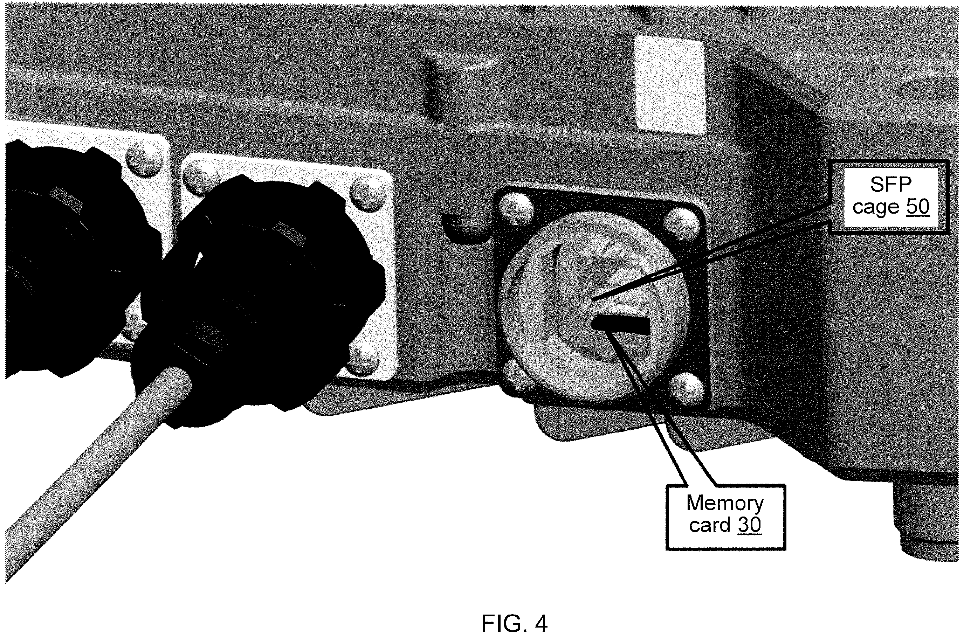

FIG. 4 depicts that the memory card 30 is installed inside the I/O connection port according to some embodiments. Note that the SFP cage 50 is still empty because the transceiver has not been plugged into the cage.

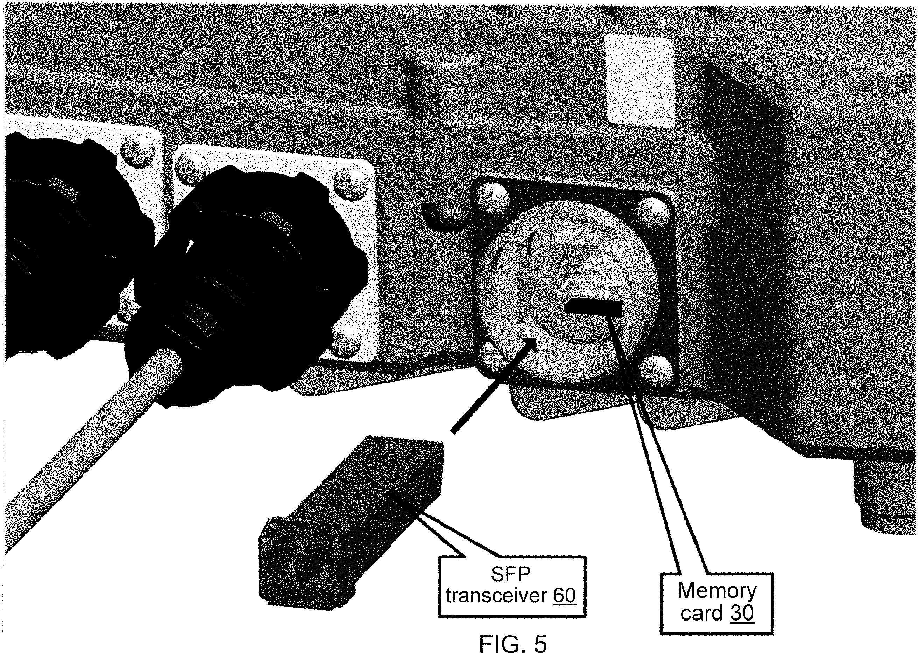

FIG. 5 depicts that an SFP transceiver 60 is being inserted into the I/O connection port according to some embodiments.

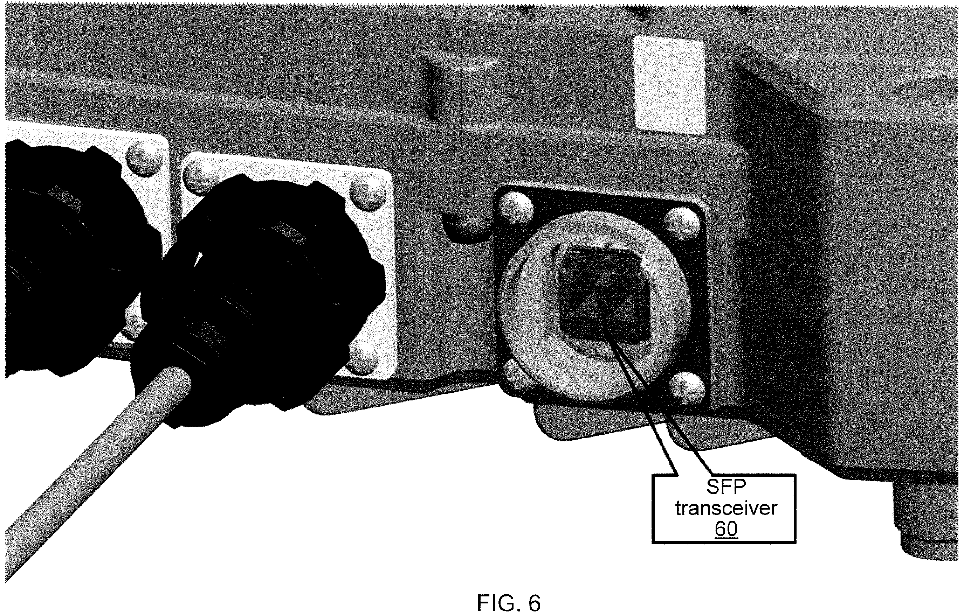

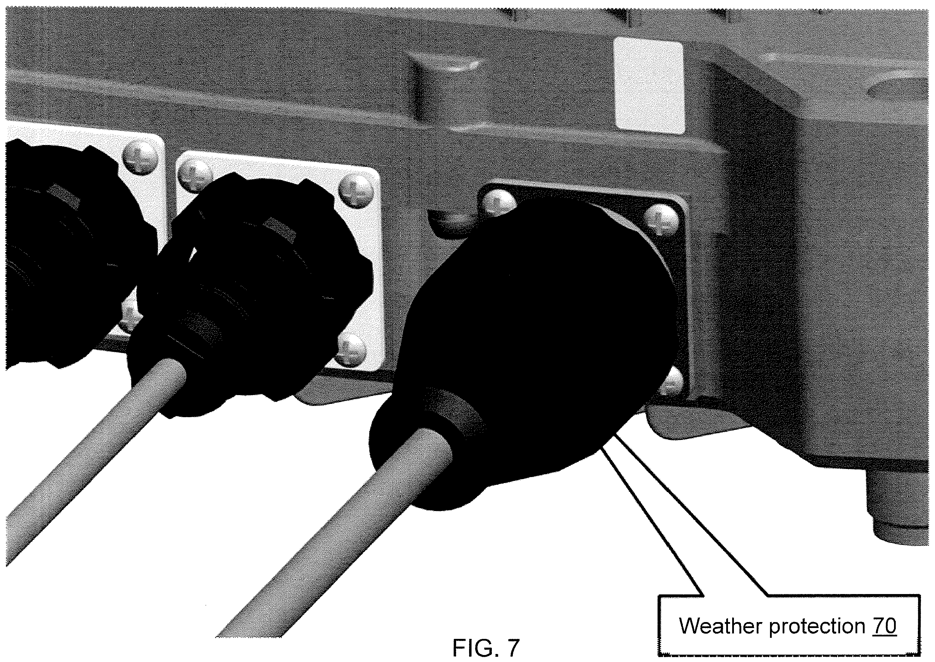

FIG. 6 depicts that the SFP transceiver 60 has been installed inside the enclosure through the I/O connection port according to some embodiments. Assuming that the newly-inserted memory card 30 (e.g., a new memory card that is used to replace an existing memory card having the same form-factor standard) has the information for upgrading the operation of the enclosure, the technician can now plug back the previously removed I/O connector with weather protection 70 as shown in FIG. 7. As noted above, the memory card 30 should be located inside the enclosure 20 in such a way that it is easy to be inserted into or removed from the enclosure 20. Additionally, the memory card's existence should not interference the normal operation of the I/O connector as well as the communication connector inside the enclosure 20 that shares the I/O connection port with the memory card 30.

FIGS. 3-7 depict, respectively an outdoor microwave enclosure 20 utilizing some embodiments of the present invention. In FIG. 3, the connector weather protection is removed to reveal the connection details. In this case, the connection is an SFP optical transceiver but the connection could be a passive fiber optic connector, Ethernet connector, or other connector type. FIG. 3 shows how the memory card 30 is removed and installed through the same I/O connection port as the SFP transceiver 60. FIG. 4 shows how the memory card 30 is installed into the memory cardholder 90 located below the sheet metal cage 50 that houses the SFP transceiver 60. FIG. 5 shows how the SFP transceiver 60, in this case with a duplex LC fiber optic connector, is installed into the SFP cage 50. FIG. 6 shows that both the SFP transceiver 60 and the memory card 30 have been appropriately installed. The duplex LC fiber optic connector is plugged into the SFP transceiver 60 and the weather protection is installed back as shown in FIG. 7.

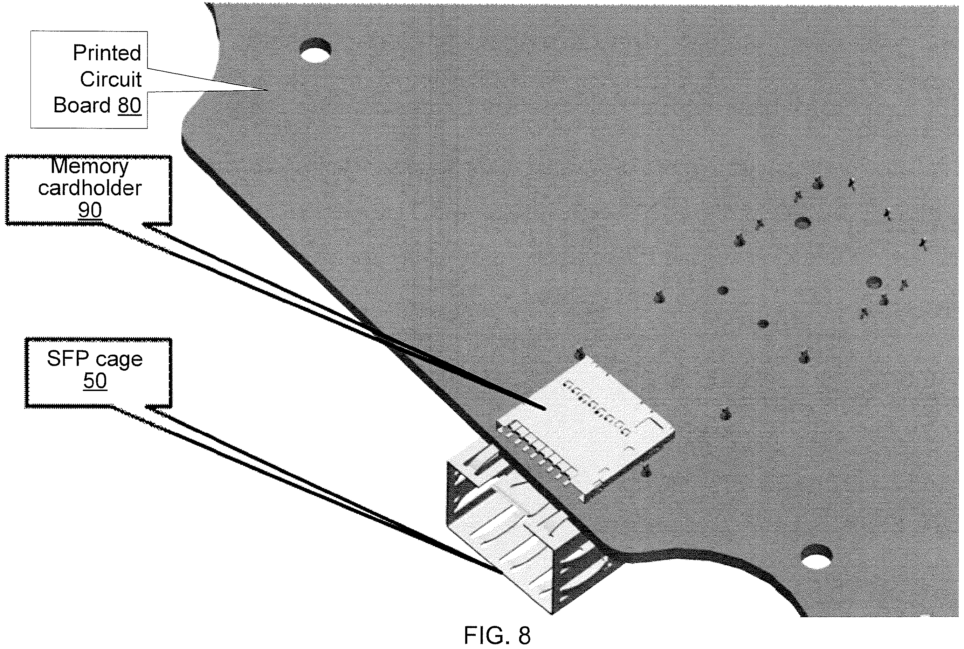

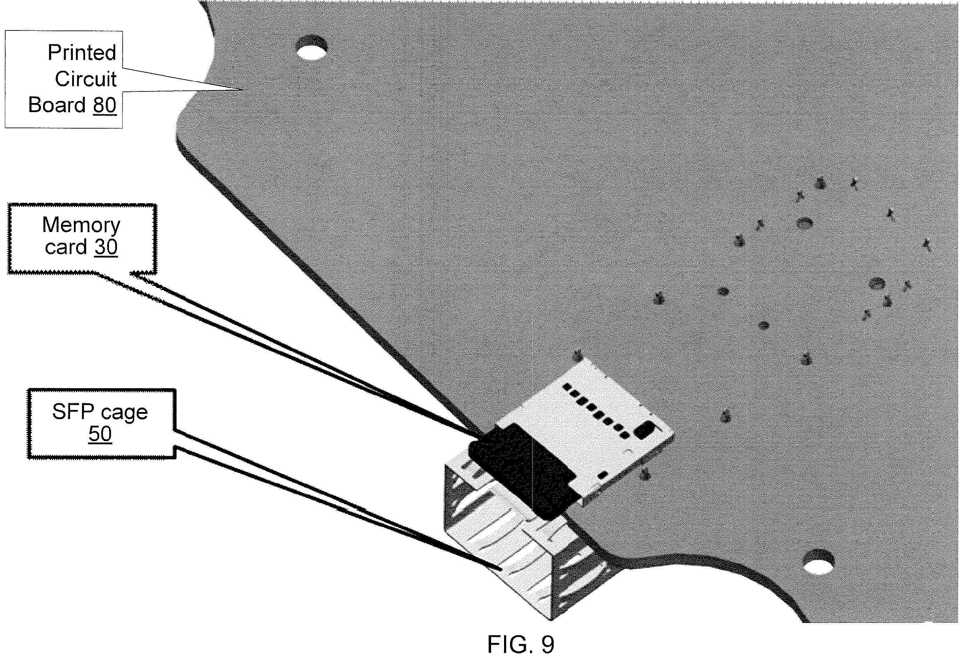

As shown in FIG. 8, the memory card 30 is housed by a memory cardholder 90 that is located at the opposite side of a printed circuit board 80 that is attached to the SFP cage 50. As such, the two components, the SFP transceiver 60 and the memory card 30 can co-exist without affecting the other one. This configuration may require a new design of the printed circuit board 80 in order for other components in the enclosure 20 to access the data stored in the memory card through the printed circuit board 80. FIG. 9 depicts that the memory card 30 is inserted into the memory cardholder 90 according to some embodiments.

FIGS. 8 and 9 depict, respectively, a close-up of the printed circuit board 80 housed within the enclosure 20. The SFP cage 50 is on one side of the board 80 and the memory cardholder 90 is on the other side. Both the SFP cage 50 and the memory cardholder 90 can be accessed through a single opening in the enclosure that is weather sealed using a single weather protection component.

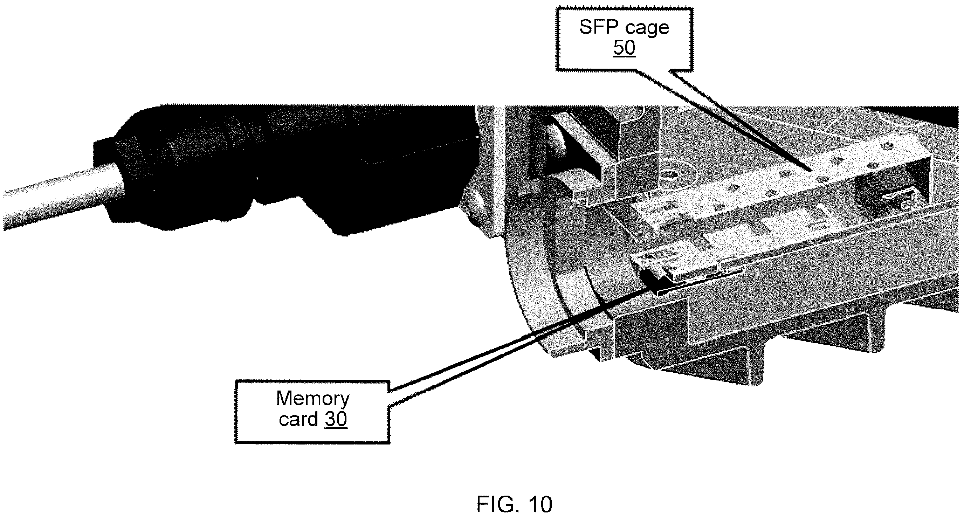

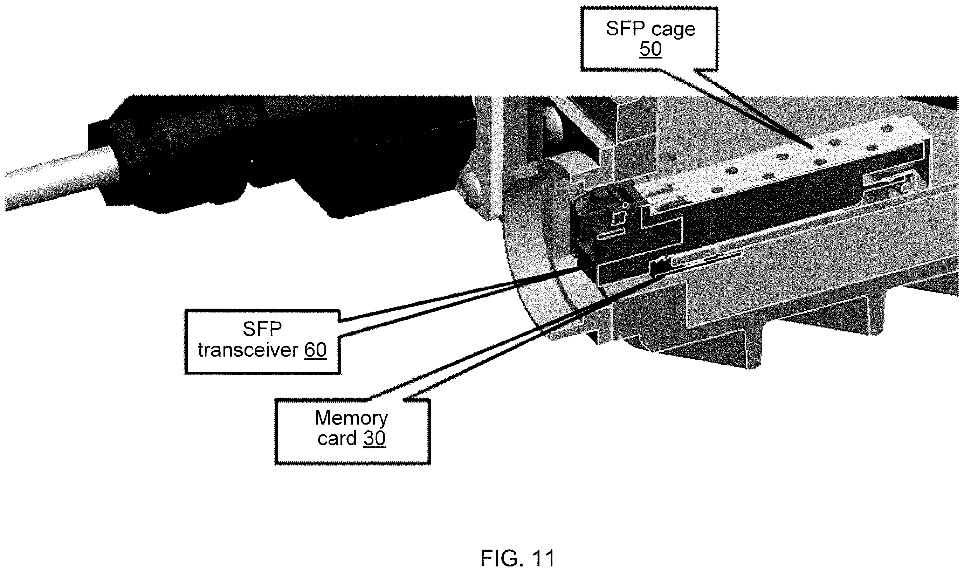

FIG. 10 depicts a cross-sectional view of the enclosure with the connector's weather protection removed and the SFP transceiver removed but the memory card installed according to some embodiments. FIG. 11 depicts a cross-sectional view of the enclosure with the connector protection removed but both the SFP transceiver and the memory card install according to some embodiments. These two cross-sectional views provide further detail of the arrangement of the SFP cage 50, the memory cardholder 90, the SFP transceiver 60, and the memory card 30 inside the microwave enclosure.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated.

## Claims

1. An all-outdoor microwave transmit/receive enclosure, comprising:
an enclosure housing, wherein the enclosure housing contains a removable communication connector and a removable memory card, wherein the removable communication connector is hosted in a cage affixed to a first side of a printed circuit board and the removable memory card is hosted in a cardholder affixed to a second side opposite the first side of the printed circuit board;
one or more I/O connection ports that are mounted on one side of the enclosure housing, wherein both the removable communication connector and the removable memory card can be inserted into or removed from the enclosure housing via a particular I/O connection port; and
one or more removable cable plug-in terminals, each removable cable plug-in terminal having a weather protection shielding and being plugged into a corresponding I/O connection port,
wherein the removable communication connector is an optical transceiver.

2. The enclosure of claim 1, wherein the optical transceiver has a standard form-factor selected from the group consisting of CFP, SFF, SFP, SFP+, XFP, and BiDi.

3. The enclosure of claim 1, wherein the removable memory card is a flash memory card.

4. The enclosure of claim 1, wherein the removable memory card is configured to store at least one of licensing information, configuration parameters, and software for operating the enclosure.

5. A method of replacing a first memory card inside an all-outdoor microwave transmit/receive enclosure with a second memory card, comprising:
unplugging a cable plug-in terminal from an I/O connection port of the enclosure, wherein the cable plug-in terminal is covered by a weather protection shielding and there are a first memory card and a removable communication connector inside the enclosure and both the first memory card and the removable communication connector are near the I/O connection port, and the removable communication connector is hosted in a cage affixed onto a first side of a printed circuit board assembly and the first memory card is hosted in a cardholder affixed onto a second side opposite the first side of the printed circuit board assembly;
removing the first memory card from the enclosure through the I/O connection port with the removable communication connector still in place;
inserting a second memory card into the enclosure through the I/O connection port to occupy a space inside the enclosure that used to be occupied by the first memory card; and
plugging the cable plug-in terminal back into the I/O connection port,
wherein the removable communication connector is an optical transceiver.

6. The method of claim 5, further comprising:
removing the optical transceiver from the enclosure through the I/O connection port; and
inserting a replacement optical transceiver into the enclosure through the I/O connection port to occupy a space inside the enclosure that used to be occupied by the removed optical transceiver.

7. The method of claim 5, wherein the optical transceiver is an optical transceiver that has a standard form-factor selected from the group consisting of CFP, SFF, SFP, SFP+, XFP, and BiDi.

8. The method of claim 5, wherein the removable memory card is a flash memory card.

9. The method of claim 5, wherein the removable memory card is configured to store at least one of licensing information, configuration parameters, and software for operating the enclosure.

## Patentansprüche

1. Allwetter-Freiluft-Mikrowellen-Sende/Empfangs-Umfassung, die Folgendes umfasst:
ein Umfassungsgehäuse, wobei das Umfassungsgehäuse einen entfernbaren Kommunikationsverbinder und eine entfernbare Speicherkarte enthält, wobei der entfernbare Kommunikationsverbinder in einem Käfig aufgenommen ist, der auf einer ersten Seite einer gedruckten Leiterplatte befestigt ist, und die entfernbare Speicherkarte in einem Kartenhalter aufgenommen ist, der auf einer zweiten Seite gegenüber der ersten Seite der gedruckten Leiterplatte befestigt ist;
einen oder mehrere E/A-Verbindungsports, die auf einer Seite des Umfassungsgehäuses montiert sind, wobei sowohl der entfernbare Kommunikationsverbinder als auch die entfernbare Speicherkarte über einen speziellen E/A-Verbindungsport in das Umfassungsgehäuse eingeschoben oder aus dem Umfassungsgehäuse entfernt werden können;und
einen oder mehrere entfernbare Kabeleinsteckanschlüsse, wobei jeder entfernbare Kabeleinsteckanschluss eine Wetterschutzabschirmung aufweist und in einen entsprechenden E/A-Verbindungsport eingesteckt ist,
wobei der entfernbare Kommunikationsverbinder ein optischer Sender/Empfänger ist.

2. Gehäuse nach Anspruch 1, wobei der optische Sender/Empfänger einen Standardformfaktor hat, der aus der Gruppe bestehend aus CFP, SFF, SFP, SFP+, XFP und BiDi ausgewählt ist.

3. Gehäuse nach Anspruch 1, wobei die entfernbare Speicherkarte eine Flash-Speicherkarte ist.

4. Gehäuse nach Anspruch 1, wobei die entfernbare Speicherkarte dafür konfiguriert ist, mindestens eines von Lizenzierungsinformationen, Konfigurationsparametern und Software zum Bedienen des Gehäuses zu speichern.

5. Verfahren zum Ersetzen einer ersten Speicherkarte im Inneren einer Allwetter-Freiluft-Mikrowellen-Sende/Empfangs-Umfassung durch eine zweite Speicherkarte, das Folgendes umfasst:
Lösen eines Kabeleinsteckanschlusses von einem E/A-Verbindungsport der Umfassung, wobei der Kabeleinsteckanschluss von einer Wetterschutzabschirmung bedeckt wird und eine erste Speicherkarte und ein entfernbarer Kommunikationsverbinder im Inneren des Gehäuse angeordnet sind und sowohl die erste Speicherkarte als auch der entfernbare Kommunikationsverbinder nahe dem E/A-Verbindungsport angeordnet sind, und der entfernbare Kommunikationsverbinder in einem Käfig untergebracht ist, der auf einer ersten Seite einer gedruckten Leiterplattenbaugruppe befestigt ist und die erste Speicherkarte in einem Kartenhalter untergebracht ist, der auf einer zweiten Seite gegenüber der ersten Seite der gedruckten Leiterplattenbaugruppe befestigt ist;
Entfernen der ersten Speicherkarte aus der Umfassung durch den E/A-Verbindungsport, während sich der entfernbare Kommunikationsverbinder immer noch an seinem Platz befindet;
Einsetzen einer zweiten Speicherkarte in die Umfassung durch den E/A-Verbindungsport, um einen Raum im Inneren der Umfassung zu belegen, der zuvor durch die erste Speicherkarte belegt worden war; und
Zurückstecken des Kabeleinsteckanschlusses in den E/A-Verbindungsport,
wobei der entfernbare Kommunikationsverbinder ein optischer Sender/Empfänger ist.

6. Verfahren nach Anspruch 5, das des Weiteren Folgendes umfasst:
Entfernen des optischen Sender/Empfängers aus der Umfassung durch den E/A-Verbindungsport; und
Einsetzen eines optischen Austausch-Sender/Empfängers in die Umfassung durch den E/A-Verbindungsport, um einen Raum im Inneren der Umfassung zu belegen, der zuvor durch den herausgenommenen optischen Sender/Empfänger belegt worden war.

7. Verfahren nach Anspruch 5, wobei der optische Sender/Empfänger ein optischer Sender/Empfänger ist, der einen Standardformfaktor hat, der aus der Gruppe bestehend aus CFP, SFF, SFP, SFP+, XFP und BiDi ausgewählt ist.

8. Verfahren nach Anspruch 5, wobei die entfernbare Speicherkarte eine Flash-Speicherkarte ist.

9. Verfahren nach Anspruch 5, wobei die entfernbare Speicherkarte dafür konfiguriert ist, mindestens eines von Lizenzierungsinformationen, Konfigurationsparametern und Software zum Bedienen des Gehäuses zu speichern.

## Revendications

1. Enceinte extérieure d'émission-réception de micro-ondes, comprenant :
un boîtier d'enceinte, dans laquelle le boîtier d'enceinte contient un connecteur de communication amovible et une carte de mémoire amovible, dans laquelle le connecteur de communication amovible est logé dans une cage fixée à un premier côté d'une carte de circuits imprimés et la carte de mémoire amovible est logée dans un support de carte fixé à un deuxième côté à l'opposé du premier côté de la carte de circuits imprimés ;
un ou plusieurs ports de connexion d'entrée/sortie, E/S, qui sont montés sur un côté du boîtier d'enceinte, dans laquelle le connecteur de communication amovible et la carte de mémoire amovible peuvent être insérés dans le boîtier d'enceinte ou retirés de celui-ci par l'intermédiaire d'un port de connexion E/S ; et
une ou plusieurs bornes de branchement de câble amovibles, chaque borne de branchement de câble amovible comportant un blindage de protection contre les intempéries et étant branchée dans un port de connexion E/S correspondant,
dans laquelle le connecteur de communication amovible est un émetteur-récepteur optique.

2. Enceinte selon la revendication 1, dans laquelle l'émetteur-récepteur optique a un facteur de forme standard sélectionné dans le groupe se composant de CFP, SFF, SFP, SFP+, XFP et BiDi.

3. Enceinte selon la revendication 1, dans laquelle la carte de mémoire amovible est une carte de mémoire flash.

4. Enceinte selon la revendication 1, dans laquelle la carte de mémoire amovible est configurée pour mémoriser au moins l'un d'informations de licence, de paramètres de configuration et de logiciels pour le fonctionnement de l'enceinte.

5. Procédé de remplacement d'une première carte de mémoire à l'intérieur d'une enceinte extérieure d'émission-réception de micro-ondes par une deuxième carte de mémoire, comprenant :
le débranchement d'une borne de branchement de câble d'un port de connexion E/S de l'enceinte, dans lequel la borne de branchement de câble est recouverte d'un blindage de protection contre les intempéries, une première carte de mémoire et un connecteur de communication amovible se trouvent à l'intérieur de l'enceinte, la première carte de mémoire et le connecteur de communication amovible sont à proximité du port de connexion E/S, le connecteur de communication amovible est logé dans une cage fixée à un premier côté d'un assemblage de carte de circuits imprimés et la première carte de mémoire est logée dans un support de carte fixé à un deuxième côté à l'opposé du premier côté de l'assemblage de carte de circuits imprimés ;
le retrait de la première carte de mémoire de l'enceinte par l'intermédiaire du port de connexion E/S avec le connecteur de communication amovible maintenu en place ;
l'insertion d'une deuxième carte de mémoire dans l'enceinte par l'intermédiaire du port de connexion E/S pour occuper un espace à l'intérieur de l'enceinte qui était auparavant occupé par la première carte de mémoire ; et
le rebranchement de la borne de branchement de câble dans le port de connexion E/S,
dans lequel le connecteur de communication amovible est un émetteur-récepteur optique.

6. Procédé selon la revendication 5, comprenant en outre :
le retrait de l'émetteur-récepteur optique de l'enceinte par l'intermédiaire du port de connexion E/S ; et
l'insertion d'un émetteur-récepteur optique de remplacement dans l'enceinte par l'intermédiaire du port de connexion E/S pour occuper un espace à l'intérieur de l'enceinte qui était auparavant occupé par l'émetteur-récepteur optique retiré.

7. Procédé selon la revendication 5, dans lequel l'émetteur-récepteur optique est un émetteur-récepteur optique ayant un facteur de forme standard sélectionné dans le groupe se composant de CFP, SFF, SFP, SFP+, XFP et BiDi.

8. Procédé selon la revendication 5, dans lequel la carte de mémoire amovible est une carte de mémoire flash.

9. Procédé selon la revendication 5, dans lequel la carte de mémoire amovible est configurée pour mémoriser au moins l'un d'informations de licence, de paramètres de configuration et de logiciels pour le fonctionnement de l'enceinte.
